Europäisches Patentamt

European Patent Office

Office européen des brevets

(19)

(11) Veröffentlichungsnummer: **0 071 664**
**B1**

(12) **EUROPÄISCHE PATENTSCHRIFT**

(45) Veröffentlichungstag der Patentschrift:
10.07.85

(51) Int. Cl.⁴: **H 01 L 21/312**

(21) Anmeldenummer: 81106205.8

(22) Anmeldetag: 07.08.81

(54) Verfahren zur Herstellung von Mikrostrukturen auf festen Körpern.

(43) Veröffentlichungstag der Anmeldung:
16.02.83 Patentblatt 83/7

(45) Bekanntmachung des Hinweises auf die Patenterteilung:
10.07.85 Patentblatt 85/28

(84) Benannte Vertragsstaaten:
AT CH DE FR GB LI NL

(56) Entgegenhaltungen:
FR - A - 2 407 499
US - A - 3 080 481

EXTENDED ABSTRACTS OF THE JOURNAL OF THE ELECTROCHEMICAL SOCIETY, Band 80-2, 1980, Seiten 848-850, Zusammenfassung Nr. 328, Pennington, N.J., USA
IBM TECHNICAL DISCLOSURE BULLETIN, Band 9, Nr. 11, April 1967, Seite 1473, New York, USA
CHEMICAL PROCESSING, Band 14, Nr. 8, August 1968, Seiten 18,19, London, G.B.
ZEITSCHRIFT FUR PHYSIK, Band 129, 1951, Seiten 491-503, Berlin, DE.
JOURNAL OF PHYSICAL CHEMISTRY, Band 67, 1963, Seiten 1784-1788, Easton, USA

(73) Patentinhaber: Fraunhofer-Gesellschaft zur Förderung der angewandten Forschung e.V., Leonrodstrasse 54, D-8000 München 19 (DE)

(72) Erfinder: Fritzsche, Christian, Dipl.-Phys., Eckerstrasse 4, D-7800 Freiburg (DE)

(74) Vertreter: Kraus, Walter, Dr. et al, Patentanwälte Kraus Weisert & Partner Thomas-Wimmer-Ring 15, D-8000 München 22 (DE)

## Beschreibung

Die Erfindung betrifft ein Verfahren zur Herstellung von Mikrostrukturen auf festen Körpern. Solche Verfahren sind von großer Bedeutung für die Herstellung von Transistoren und integrierten Schaltungen; sie sind aber auch für andere Zweige der Technik von Bedeutung. Sie spielen u. a. dann eine große Rolle, wenn die Strukturen so klein sind, daß das Auflösungsvermögen oder die Justiergenauigkeit lichtoptischer Verfahren nicht mehr ausreicht.

Bei den bisher üblichen Photolithographieverfahren wird zunächst die gesamte Oberfläche des festen Körpers mit einem lackähnlichen Material, das auch als Photoresist oder Elektronenresist bezeichnet wird, überzogen. Bei der Bestrahlung mit Photonen oder Elektronen ändert das Material seine Löslichkeit. Werden nun bestimmte Stellen der Schicht bestrahlt und andere nicht, so erhält man bei der anschließenden Entwicklung mittels eines Lösungsmittels eine Struktur, d. h. ein Teil des festen Körpers ist mit der Schicht bedeckt, und ein Teil liegt frei. Die freiliegenden Stellen des festen Körpers können dann angeätzt werden.

Dieses bekannte Verfahren, das heute vielfach Anwendung findet, besitzt den Nachteil, daß zur Herstellung der Mikrostrukturen mehrere Schritte erforderlich sind, daß zur Entwicklung ein Lösungsmittel verwendet werden muß und daß bei den derzeit verfügbaren Resistmaterialien »pinholes«, schlechte Haftung der Schicht und Quellung die Exaktheit der Strukturübertragung beeinträchtigen oder die Ausbeute in der Produktion vermindern.

In der französischen Patentanmeldung Nr. 2 407 499 wird ein Verfahren zur Herstellung von Mikrostrukturen auf einem festen Körper beschrieben, bei dem eine strukturierte Deckschicht durch Ionenätzen auf das Material eines festen Körpers übertragen wird.

Aus der Zusammenfassung des Artikels von W. Larson u. a. mit dem Titel »Plasma etch processing for electron resists« in »Extended abstracts of the Journal of the Electrochemical Society«, Band 80-2, 1980, Seiten 848—850, ist es weiterhin bekannt, daß die Plasmaätzung eine bekannte Alternative zur Ionenätzung ist.

Der vorliegenden Erfindung liegt die Aufgabe zugrunde, ein Verfahren zur Herstellung von Mikrostrukturen auf festen Körpern zur Verfügung zu stellen, welches auf einfache Weise durchzuführen ist, nicht so viele Stufen wie das bekannte Verfahren umfaßt und bei dem insbesondere auf die Verwendung von Lösungsmitteln verzichtet werden kann. Ebenso soll der auf die Maskierung folgende Ätzprozeß nicht naß sondern trocken, zum Beispiel durch Plasmaätzen, ausgeführt werden. Mit dem erfindungsgemäßen Verfahren soll weiterhin die Ausbeute besser als bei den herkömmlichen Verfahren sein, auch wenn die Zahl der Strukturen auf einer Fläche sehr groß ist.

Die Erfindung betrifft ein Verfahren zur Herstellung von Mikrostrukturen auf einem festen Körper, bei dem eine strukturierte Deckschicht aus einem gegen Plasmaätzung unempfindlichen Material durch Abscheiden eines polymerisierbaren Gases unter Bestrahlung erzeugt wird und bei dem die Struktur der Deckschicht durch Plasmaätzen auf das Material des festen Körpers übertragen wird, das dadurch gekennzeichnet ist, daß vor der Erzeugung der strukturierten Deckschicht auf dem festen Körper eine die laterale Streuung von Elektroden einengende Zwischenschicht aufgebracht wird und daß ihre von der strukturierten Deckschicht nicht abgedeckten Teile vor dem Übertragen der Struktur auf den Körper abgetragen werden.

Bevorzugt wird mittels der Strahltechnik eine strukturierte Deckschicht aus einem polymeren, gegen Plasmaätzung unempfindlichen Material auf dem festen Körper erzeugt.

Gemäß einer besonderen erfindungsgemäßen Ausführungsform des Verfahrens zur Herstellung von Mikrostrukturen auf festen Körpern mittels Strahltechnik wird zunächst auf dem festen Körper eine die Polymerisation fördernde Katalysatorschicht aufgebracht, diese wird mittels der Strahltechnik strukturiert abgetragen, danach wird auf der Katalysatorschicht eine Deckschicht aus einem polymeren Material, das gegen Plasmaätzung unempfindlich ist, erzeugt, und danach wird die Struktur der Deckschicht auf das unter ihr liegende Material des festen Körpers durch Plasmaätzung übertragen.

Die Erfindung betrifft weiterhin ein Verfahren zur Herstellung von Mikrostrukturen auf festen Körpern mittels Elektronenstrahl-Lithographie, das dadurch gekennzeichnet ist, daß das zu bearbeitende Material vor dem Aufbringen des die Struktur definierenden Resists mit einer dünnen Schicht eines elektrisch leitenden oder halbleitenden Materials überzogen wird, welche im Verlauf der weiteren Prozeßschritte ganz oder teilweise wieder entfernt wird.

Die Erfindung beruht auf der Feststellung, daß Polymerisate des Restgases in Elektronenmikroskopen, die sich unter dem Einfluß des Strahles auf dem Objekt bilden (H. König und G. Helwig, Z. Physik 129, 491 (1951)), außerordentlich resistent gegen Plasmaätzung sind.

Hierbei spielen die besonderen Eigenschaften des Plasmaätzens, wie zum Beispiel die Bildung außerordentlich reaktiver Molekülbruchstücke, eine besondere Rolle, und die Kombination der vorgeschlagenen Techniken mit dem Plasmaätzen wird als besonders wichtiges Merkmal betrachtet.

Bei dem erfindungsgemäßen Verfahren kann man als Festkörper alle die Materialien nehmen, die in der Vergangenheit bereits zur Herstellung von integrierten Schaltungen, Transistoren usw. verwendet wurden. Beispiele sind Silicium und Galliumarsenid, die gegebenenfalls mit Siliciumdioxid ($SiO_2$) und Siliciumnitrid ($Si_3N_4$) beschichtet sein können. Die Festkörper können als dünne Scheiben bis zu mehreren Zoll Durchmesser vorliegen. Die obigen Verfahren beziehen sich jedoch nicht auf freitragende Schichten, die dünner als 10 µm sind, oder dünne Schichten auf einer über einen Rahmen gespannten dünnen Stützschicht, bei denen die weiter unten beschriebenen Schwierigkeiten der Strukturunschärfe infolge Elektronenrückstreuung nicht bestehen und die auch in der Halbleitertechnik keine Bedeutung haben (W. W. Molzen, A. N. Broers, et al., J. Vac. Sci. Technol. 16 (2), 1979, Seite 269).

Erfindungsgemäß wird auf dem festen Körper mittels Strahltechnik, beispielsweise mittels eines Elektronen-, Ionen- oder Photonenstrahls (E. V. Weber, R. D. Moore, Solid State Technol, Mai 1979, Seite 61), eine strukturierte Deckschicht aus einem polymeren (J. Haller, P. White, J. Phys. Chemistry 67 (1963), Seite 1784), gegen Plasmaätzung unempfindlichen Material erzeugt. Diese strukturierte Deckschicht kann auch als Resist bezeichnet werden. Bei einer anderen erfindungsgemäßen Ausführungsform wird zuerst auf den festen Körper eine strukturierte Katalysatorschicht aufgebracht. Die Aufbringung der Deck- bzw. Katalysatorschichten erfolgt durch Verdampfung oder Kathodenzerstäubung, die Strukturierung durch Ausbrennen mit einem Elektronen- oder Laserstrahl.

Die Dicke der strukturierten Schichten beträgt im allgemeinen weniger als 200 nm, vorzugsweise 50 bis 70 nm. Wird auf dem festen Körper zuerst eine Katalysatorschicht erzeugt, so bildet sich bei der anschließenden Polymerisation die Polymerenschicht nur auf der strukturierten Katalysatorschicht, und die anderen Teile des festen Körpers, die frei sind von der Katalysatorschicht, bleiben auch deckschichtfrei. Die Herstellung der Deckschicht aus dem polymeren Material erfolgt durch strahl- oder plasmainduzierte Polymerisation eines monomeren Gases. Die Struktur der polymeren Materialien ist nicht bekannt. Man nimmt jedoch an, daß ein Teil der monomeren Moleküle aus dem Gasraum ohne wesentliche Strukturänderung in das Polymerisat eingebaut wird, während andere aufgebrochen werden und die Polymerisation in Gang setzen. Als organische Materialien zur Herstellung der Deckschicht kann man all solche Materialien nehmen, die einen ausreichend hohen Dampfdruck aufweisen, so daß im Strahlraum ein Druck von mehr als $10^{-4}$ mbar aufrechterhalten werden kann, die aber andererseits auch eine gegen Plasmaätzung unempfindliche Deckschicht ergeben. Durch den Dampfdruck unterscheiden sie sich von den Pumpenölen, aus denen zwar auch geeignete Schichten abgeschieden werden können, die aber wegen ihrer gleichzeitigen Verwendung zum Pumpen einen niedrigen Dampfdruck haben und daher nur eine sehr langsame Abscheidung gestatten. Beispiele geeigneter organischer Materialien sind ungesättigte Kohlenwasserstoffe mit $C_1$ bis $C_{10}$ Kohlenstoffatomen, die geradlinig oder verzweigt sein können. Beispiele hierfür sind Äthylen, Butadien, Octen etc.; Cycloalkane mit 5 bis 10 Kohlenstoffatomen, wie Cyclopentan, Cyclohexan, Cyclooctan und Cycloalkene mit 1 bis 10 Kohlenstoffatomen, beispielsweise Cyclopentadien. Man kann auch Derivate dieser Verbindungen verwenden. Erfindungsgemäß kann man außerdem zur Herstellung der polymeren Verbindungen Benzol und Naphthalin sowie deren Derivate, wie beispielsweise Chlorbenzol, Toluol, Äthylnaphthalin, verwenden. Andere Beispiele, die erfindungsgemäß eingesetzt werden können, sind Picolin, Diphenyl, Terphenyl, Tetraäthylorthosilicat zusammen mit Sauerstoff, Divinylbenzol und/ oder Styrol.

Bevorzugt werden ungesättigte Kohlenwasserstoffe, deren Dampfdruck bei Raumtemperatur größer ist als $10^{-4}$ mbar, vorzugsweise cyclische Verbindungen mit angefügten Vinylgruppen oder deren Mischungen mit einfachen Verbindungen, wie zum Beispiel eine Mischung von Divinylbenzol mit Naphthalin, verwendet.

Bevorzugt verwendet man Butadien, Cyclopentan oder Cyclopentadien oder deren Derivate, Chlorbenzol, Toluol, Naphthalin, Picolin, Diphenyl, Terphenyl, Tetraäthylorthosilicat und Sauerstoff, Divinylbenzol oder Styrol.

Die Schichtabscheidung hängt stark von der Wahrscheinlichkeit ab, mit der ein gegen das Substrat stoßendes Gasmolekül an diesem haften bleibt. Die Anmelderin hat gefunden, daß es von Vorteil ist, das Substrat während der Abscheidung auf eine Temperatur unter 20° C, aber über der Kondensationstemperatur des monomeren Gases bei dem eingestellten Druck zu kühlen.

Die abgeschiedene Schicht braucht auch nicht aus einem polymerisierten organischen Material zu bestehen. Es ist nur notwendig, daß sie beim Plasmaätzen erheblich weniger angegriffen wird als das darunter liegende Material (A. T. Bell, Solid State Technology, April 1978, Seite 89). Dies gilt zum Beispiel auch für $SiO_2$, das aus einer Mischung von Sauerstoff und Tetraäthylorthosilicat mit einer Glimmentladung auf Silicium abgeschieden wird, wenn man die Plasmaätzung in einem Gemisch aus $CF_4$ und $O_2$ ausführt. Hat man auf dem festen Körper zuerst eine Katalysatorschicht aufgedampft und wie oben beschrieben strukturiert, so reicht zur strukturierten Abscheidung der eigentlichen Deckschicht, d. h. des Resists, eine Glimmentladung, oder man kann die polymere Schicht mittels UV-Licht oder Röntgenstrahlen abscheiden.

Die Bedeutung der Erfindung liegt darin, daß feinere Strukturen als mit optischer Photolithographie hergestellt werden können, daß die Plasmaätzkammer gleichzeitig Targetkammer für die strukturierte Beschichtung sein kann und daß auch weiter Prozesse, wie zum Beispiel Ionenimplantation, in der gleichen Kammer ausgeführt werden können. Wegen des Wegfallens eines nassen Entwicklungsprozesses kann das Material ständig in der Kammer bleiben.

Hierdurch entfällt beim Aufbringen einer zweiten Struktur die sonst erforderliche Justierung der Strukturen gegeneinander. Damit sind wesentliche Voraussetzungen für eine Automatisierung geschaffen.

Bei dem erfindungsgemäßen Verfahren und allgemein in der Elektronenstrahl-Lithographie werden die zu behandelnden Materialien mit einem gegen Ätzung, insbesondere Plasmaätzung, beständigen Material, dem sogenannten Resist, überzogen, wobei der Elektronenstrahl dazu dient, den Resistüberzug sofort oder nachträglich mit größter Genauigkeit auf bestimmte Teile der Oberfläche zu beschränken.

Bei den bisher bekannten Verfahren wird die Genauigkeit durch rückgestreute Elektronen beeinträchtigt, weil diese dieselbe Wirkung aber nicht dieselbe Richtung haben wie die eingestrahlten Elektronen.

Die Anmelderin hat nun gefunden, daß die laterale Streuung der Elektronen eingeengt und damit die Schärfe der Struktur weiter verbessert werden kann, wenn man vor dem Aufbringen des Resists das zu strukturierende Material mit einer elektrisch leitenden oder halbleitenden Schicht hoher Dichte aber geringer Dicke überzieht. Dadurch wird die Eindringtiefe und damit der Rückstreubereich während der Bestrahlung vermindert. Diese Schicht aus elektrisch leitendem oder halbleitendem Material wird an den von der Polymerschicht nicht bedeckten Stellen durch Plasmaätzen entfernt. Diese Ätzung kann getrennt oder gleichzeitig mit der zur Strukturübertragung dienenden plasmaätzung ausgeführt werden. Die restliche Schicht kann nachträglich entfernt werden, wenn man zuvor die Polymerschicht durch Veraschung im Sauerstoffplasma entfernt, doch erstreckt sich die Erfindung auch auf den Fall, daß die restliche Schicht stehengelassen wird.

Als Material für die Zwischenschicht verwendet man ein solches mit einer Dichte größer oder gleich 5,3 g/cm³, vorzugsweise Chrom, Nickel, Germanium, Molybdän, Indium, Zinn oder Wismut. Die Schichtdicke ist nicht sehr kritisch; sie sollte aber größer oder gleich der halben Eindringtiefe des Elektronenstrahls in diese Schicht oder kleiner oder gleich der vollen Eindringtiefe des Elektronenstrahls in diese Schicht sein. Bevorzugt ist sie größer der halben und kleiner der vollen Eindringtiefe des Elektronenstrahls in diese Schicht. Wählt man die Schichtdicke größer als die halbe Eindringtiefe der Elektronen, bezogen auf die Schicht, so können nur noch solche Elektronen aus der Oberfläche austreten, die in der Schicht zurückgestreut werden, und die Unschärfe ist höchstens gleich der Schichtdicke. Ferner verhinder die elektrische Leitfähigkeit der Schicht Störungen durch Aufladung des Grundmaterials, wenn dies ein Isolator, zum Beispiel SiO₂, ist. Die Schichtdicke darf zwar größer sein als die volle Eindringtiefe, doch behindern zu dicke Schichten die nachfolgenden Ätzprozesse.

Anhand der Zeichnung wird die Wirkung der Zwischenschicht näher erläutert.

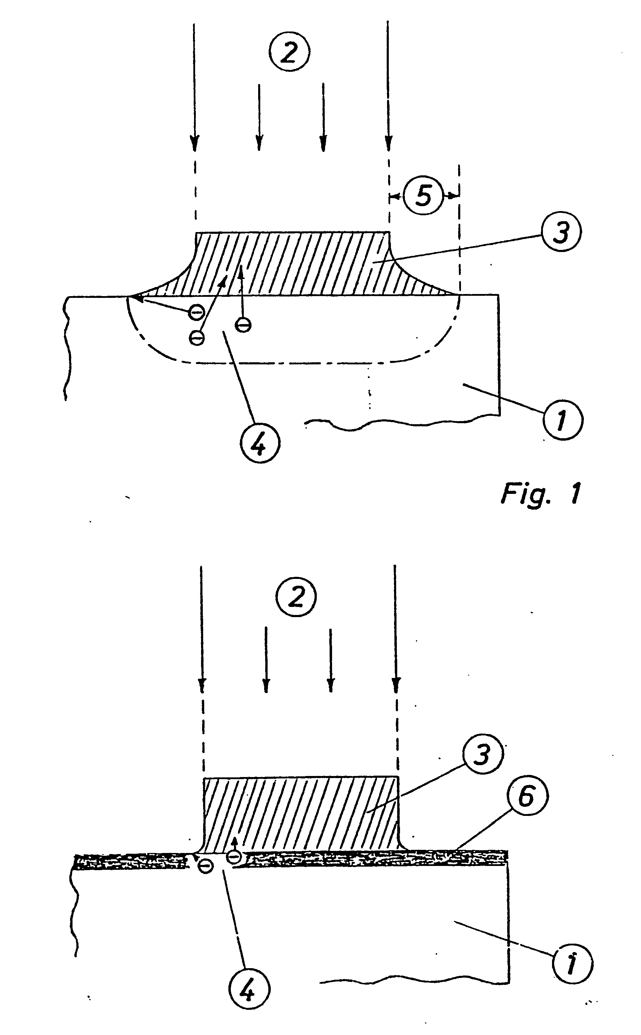

In Fig. 1 werden die Verhältnisse dargestellt, wenn die erfindungsgemäße Zwischenschicht nicht vorhanden ist, und zwar am Beispiel der lokalen Abscheidung des Resists mittels Elektronenstrahlpolymerisation, wie oben beschrieben. Auf das zu bearbeitende Material 1 trifft der scharf begrenzte Elektronenstrahl 2. Die Elektronenstrahl-Apparatur enthält ein organisches Gas, das am Material 1 adsorbiert und durch den Strahl polymerisiert wird, wobei die als Resist verwendete Polymerschicht 3 aufwächst. Die rückgestreuten Elektronen 4 tragen zur Polymerisation bei, haben aber keine wohldefinierte Richtung mehr und verursachen dadurch die Rand-Unschärfe 5, welche etwa der Tiefe des strichpunktiert gezeichneten Austrittsvolumens der Rückstreu-Elektronen entspricht.

In Fig. 2 ist die Wirkungsweise der Zwischenschicht 6 dargestellt. Diese besteht, wie oben angegeben, aus einem Material, dessen Dichte mindestens gleich 5,3 g/cm³ ist und größer ist als die des Grundmaterials. Wählt man die Schichtdicke größer als die halbe Eindringtiefe der Elektronen, bezogen auf die Schicht, so können nur noch solche Elektronen aus der Oberfläche austreten, die in der Schicht 6 zurückgestreut werden, und die Unschärfe ist höchstens gleich der Schichtdicke.

Die gleiche Wirkung besitzt die Zwischenschicht auch, wenn die Resistschicht nicht durch Elektronenstrahlpolymerisation sondern, wie bisher üblich, naß aufgebracht und mittels Elektronenstrahl die Löslichkeit lokal verändert wird. Bei dicken Resistschichten ist dann allerdings die Streuung im Resist zusätzlich zu berücksichtigen.

Die folgenden Beispiele erläutern die Erfindung.

### Beispiel 1

Als zu strukturierendes Material verwendet man Silicium, welches mit einer SiO₂-Schicht überzogen ist. Auf dieses Material wird zunächst eine Molybdänschicht von 0,035 µm bis 0,08 µm Dicke aufgedampft. Die Schichtdicke wird auf ein Flächengewicht von mehr als 30 µg/cm² eingestellt. Auf diese Schicht wird die Resiststruktur mittels Elektronenstrahl-Polymerisation bei einer Strahlenenergie von 8 keV aufgebracht. Werden andere Strahlenenergien verwendet, so ist das Flächengewicht der Zwischenschicht in gleichem Maße zu ändern, wie sich die Eindringtiefe ändert. Nach Aufbringen der Resiststruktur wird die Molybdänschicht, soweit sie nicht vom Resist bedeckt ist, durch Plasmaätzung in CF₄ + O₂ oder auch in chlorhaltigen Gasen entfernt. Es ist nicht schädlich, wenn dabei die unter der Mo-Schicht liegende und zu strukturierende Schicht bereits mit angegriffen wird. Auf die Abätzung der freiliegenden Mo-Schicht folgt die Ätzung der darunterliegenden Schicht sowie die Entfernung des Resists nach bereits bekannten und üblichen Verfahren. Die unter dem Resist befindliche Mo-Schicht kann je nach Weiterverarbeitung des Grundmaterials entweder verbleiben, zum Beispiel wenn unter ihr eine als Leiterbahn dienende Metallschicht liegt, oder sie kann durch Plasmaätzen in den obengenannten Gasen entfernt werden.

### Beispiel 2

Man arbeitet wie in Beispiel 1 beschrieben, verwendet jedoch als Substrat Siliciumdioxid mit einer Aluminiumschicht. Man erhält die gleichen Ergebnisse wie bei Beispiel 1.

### Beispiel 3

Man arbeitet wie in Beispiel 1 beschrieben, verwendet jedoch als Substrat Siliciumdioxid mit einer Aluminiumschicht und Substratkühlung während der Polymerisation. Man erhält die gleichen Ergebnisse wie bei Beispiel 1.

### Beispiele 4 bis 12

Man arbeitet wie in den Beispielen 1 und 2 beschrieben und verwendet die dort beschriebenen Substrate. Anstelle von Molybdän verwendet man jedoch Chrom, Germanium, Indium, Zinn oder Wismut. Man erhält dabei ähnliche Ergebnisse wie bei den Beispielen 1 und 2.

### Patentansprüche

1. Verfahren zur Herstellung von Mikrostrukturen auf einem festen Körper, bei dem eine strukturierte Deckschicht (3) aus einem gegen Plasmaätzung unempfindlichen Material durch Abscheiden eines polymerisierbaren Gases unter Bestrahlung erzeugt wird und bei dem die Struktur der Deckschicht durch Plasmaätzen auf das Material des festen Körpers übertragen wird, dadurch gekennzeichnet, daß vor der Erzeugung der strukturierten Deckschicht auf dem festen Körper (1) eine die laterale Rückstreuung von Elektronen einengende Zwischenschicht (6) aufgebracht wird und daß ihre von der strukturierten Deckschicht nicht abgedeckten Teile vor dem Übertragen der Struktur auf den Körper abgetragen werden.

2. Verfahren zur Herstellung von Mikrostrukturen auf festen Körpern mittels Strahltechnik, dadurch gekennzeichnet, daß zunächst auf dem festen Körper eine die Polymerisation fördernde Katalysatorschicht aufgebracht wird, diese mittels der Strahltechnik strukturiert abgetragen wird, danach auf der Katalysatorschicht eine Deckschicht aus einem polymeren Material, das gegen Plasmaätzung unempfindlich ist, erzeugt wird und danach die Struktur der Deckschicht auf das unter ihr liegende Material des festen Körpers durch Plasmaätzen übertragen wird.

3. Verfahren nach Anspruch 1 oder 2, dadurch gekennzeichnet, daß man für die Herstellung der Deckschicht Butadien, Cyclopentan oder Cyclopentadien oder deren Derivate, Chlorbenzol, Toluol, Naphthalin, Picolin, Diphenyl, Terphenyl, Tetraäthylorthosilicat und Sauerstoff, Divinylbenzol oder Styrol verwendet.

4. Verfahren nach Anspruch 2, dadurch gekennzeichnet, daß die Katalysatorschicht aus Molybdäntrioxid besteht.

5. Verfahren nach einem der Ansprüche 1 bis 3, dadurch gekennzeichnet, daß die Abscheidung des Polymeren mittels eines Elektronenoder Ionenstrahls oder eines Laserstrahls geschieht.

6. Verfahren nach einem der Ansprüche 2, 3 und 4, dadurch gekennzeichnet, daß die Abscheidung der Polymerschicht mittels einer Glimmentladung, UV-Licht oder Röntgenstrahlung geschieht.

7. Verfahren nach Anspruch 1 oder 2 und 3, dadurch gekennzeichnet, daß das Substrat während der Erzeugung des gegen Plasmaätzen unempfindlichen Materials auf einer Temperatur niedriger als 20° C, aber höher als die Kondensationstemperatur des modernen Ausgangsmaterials beim eingestellten Gasdruck ist.

8. Verfahren zur Herstellung von Mikrostrukturen auf festen Körpern mittels Elektronenstrahl-Lithographie, insbesondere nach einem der Ansprüche 1, 3 oder 5, dadurch gekennzeichnet, daß das zu bearbeitende Material vor dem Aufbringen des die Struktur definierenden Resists mit einer dünnen Schicht eines elektrisch leitenden oder halbleitenden Materials überzogen wird, welche im Verlauf der weiteren Prozeßschritte ganz oder teilweise wieder entfernt wird.

9. Verfahren nach Anspruch 8, dadurch gekennzeichnet, daß als Schichtmaterial ein solches mit einer Dichte größer oder gleich 5,3 g/ cm$^3$, vorzugsweise Chrom, Nickel, Germanium, Molybdän, Indium, Zinn oder Wismut, verwendet wird.

10. Verfahren nach Anspruch 8 oder 9, dadurch gekennzeichnet, daß die Schichtdicke größer als oder gleich der halben Eindringtiefe des Elektronenstrahls in dieser Schicht ist.

11. Verfahren nach Anspruch 8 oder 9, dadurch gekennzeichnet, daß die Schichtdicke kleiner als oder gleich der vollen Eindringtiefe des Elektronenstrahls in dieser Schicht ist.

### Claims

1. A process for producing microstructures on a solid body in which a structured surface layer (3) of a material resistant to plasma etching is produced by the deposition of a polymerizyble gas under irradiation and in which the structure of the surface layer is transferred to the material of the solid body by plasma etching, characterized in that, before the structured surface layer is formed on the solid body (1), an intermediate layer (6) concentrating the lateral back-scattering of electrons is applied and in that those parts of the intermediate layer which are not convered by the structured surface layer are removed by etching before the structure is applied to the solid body.

2. A process for producing microstructures on solid bodies by radiation, characterized in that a polymerization-promoting catalyst layer is first applied to the solid body and then etched away leaving a structure by radiation, after which a surface layer of a polymeric material resistant to plasma etching is formed on the catalyst layer and, thereafter, the structure of the surface layer is transferred to the underlying material of the solid body by plasma etching.

3. A process as claimed in claim 1 or 2, characterized in that butadiene, cyclopentane or cyclopentadiene or derivatives thereof, chlorobenzene, toluene, naphthalene, picoline, diphenyl, terphenyl, tetraethyl, orthosilicate and axogen, divinyl benzene or styrene is used für the production of the surface layer.

4. A process as claimed in claim 2, characterized in that the catalyst layer consists of molybdenum trioxide.

5. A process as claimed in any of claims 1 to 3, characterized in that deposition of the polymer is effected by an electron or ion beam or a laser beam.

6. A process as claimed in any of claims 2, 3 and 4, characterized in that deposition of the polymer layer is effected by a glow discharge, UV-light or X-rays.

7. A process as claimed in claim 1, 2 or 3, characterized in that, during production of the material resistant to plasma etching, the substrate is at a temperature lower than 20°C, but higher than the condensation temperature of the monomeric starting material at the particular gas pressure adjusted.

8. A process for producing microstructures on solid bodies by electron beam lithography, more particularly as claimed in any of claims 1, 3 and 5, characterized in that, before the resist defining the structure us applied, the material to be treated is coated with a thin layer of an electrically conductive or semiconductive material which is partly or completely removed again during the further process steps.

9. A process as claimed in claim 8, characterized in that the layer material used is one having a density of greater than or equal to 5,3 g/cm³, preferably chromium, nickel, germanium, molybdenum, indium, tin or bismuth.

10. A process as claimed in claim 8 or 9, characterized in that the layer thickness is greater than or equal to half the depth of penetration of the electron beam in that layer.

11. A process as claimed in claim 8 or 9, characterized in that the layer thickness is less than or equal to the full depth of penetration of the electron beam in that layer.

**Revendications**

1. Procédé de fabrication de microstructures sur un corps solide, dans lequel on produit une couche de couverture structurée (3) en un matériau insensible à l'attaque plasmatique par condensation d'un gaz polymérisable sous l'action du rayonnement et dans lequel l'on transfère la structure de la couche de couverture sur le matériau du corps solide par attaque plasmatique, caractérisé en ce qu'avant l'obtention de la couche de couverture structurée sur le corps solide (1), on rapporte une couche intermédiaire (6) réduisant la rétrodiffusion latérale d'électrons, et en ce qu'on enlève ses parties non recouvertes par la couche de couverture structurée avant de transférer la structure sur le corps.

2. Procédé de fabrication de microstructures sur des corps solides par la technique du rayonnement, caractérisé en ce qu'on applique d'abord sur le corps solide une couche de catalyseur accélérant la polymérisation, en ce qu'on l'enlève de façon structurée par la technique du rayonnement, en ce que l'on produit sur la couche de catalyseur une couche de couverture constituée par une matière polymère insensible à l'attaque plasmatique, et en ce que l'on transfère ensuite la structure de la couche de couverture sur le matériau du corps solide qui se trouve sous elle par attaque plasmatique.

3. Procédé selon la revendication 1 ou la revendication 2, caractérisé en ce que, pour la fabrication de la couche de couverture, on utilise du butadiène, du cyclopentane ou du cyclopentadiène, ou bien leurs dérivés, du chlorobenzène, du toluène, du naphthalène, de la picoline, du dephényle, du terphényle, de l'orthosilicate de tétraéthyle et de l'oxygène, du divinylbenzène ou du styrène.

4. Procédé selon la revendication 2, caractérisé en ce que la couche de catalyseur est constituée par du trioxyde de molybdène.

5. Procédé selon l'une quelconque des revendications 1 à 3, caractérisé en ce que le dépôt par condensation du polymère est obtenu au moyen d'un rayonnement électronique ou ionique, ou d'un faisceau laser.

6. Procédé selon l'une quelconque des revendications 2, 3 et 4, caractérisé en ce que le dépôt par condensation de la couche de polymère est obtenu par décharge lumineuse, par rayonnement ultra-violet ou au moyen de rayons X.

7. Procédé selon la revendication 1 ou 2 et la revendication 3, caractérisé en ce que, pendant l'obtention du matériau insensible à l'attaque plasmatique, le substrat est à une température inférieure à 20°C, mais supérieure à la température de condensation du matériau de départ monomère, à la pression gazeuse établie.

8. Procédé de fabrication de microstructures sur des corps solides par lithographie à rayons d'électrons, notamment selon l'une quelconque des revendications 1, 3 ou 5, caractérisé en ce qu'avant d'appliquer le matériau »résiste« définissant la structure, on recouvre le matériau à traiter d'une mince couche d'une matière électriquement conductrice ou semi-conductrice, laquelle est entièrement ou partiellement à nouveau retirée au cours des stades opératoires suivants.

9. Procédé selon la revendication 8, caractérisé en ce qu'on utilise comme matière de la couche mince une matière présentant un poids spécifique supérieur ou égal à 5,3 g/cm³, de préférence du chrome, du nickel, di germanium, du molybdène, de l'indium, de l'étain ou du bismuth.

10. Procédé selon la revendication 8 ou la revendication 9, caractérisé en ce que l'épaisseur de la couche est supérieure ou égale à la moitié de la profondeur de pénétration du rayon d'électrons dans cette couche.

11. Procédé selon la revendication 8 ou la revendication 9, caractérisé en ce que l'épaisseur de couche est inférieure ou égale à le profondeur de pénétration totale du rayon d'électrons dans cette couche.

Fig. 1